# EUROPÄISCHE PATENTANMELDUNG

(11) **EP 1 371 996 A2**
(43) Veröffentlichungstag der Anmeldung: **17.12.2003**
(21) Anmeldenummer: 03011289.0
(22) Anmeldetag: 17.05.2003
(51) Int. Cl.: G01R 33/30

(54) **Vorrichtung zur Positionierung eines länglichen Probenröhrchens relativ zu einem NMR-Empfangsspulensystem**

(30) Priorität: 12.06.2002 DE 10225958
(71) Anmelder: Bruker BioSpin AG, 8117 Fällanden (CH)
(72) Erfinder: Fey, Michael, 5075 Hornussen (CH); Urfer, Marcel, 5600 Lenzburg (CH)
(74) Vertreter: KOHLER SCHMID + PARTNER

(57) **Zusammenfassung**

Eine Vorrichtung zur Zentrierung eines mit einer Messsubstanz gefüllten länglichen Probenröhrchens (8) relativ zur Vertikalachse eines Kernspinresonanz (=NMR)-Empfangspulensystems (9), das in einer Trägervorrichtung starr befestigt ist, ist dadurch gekennzeichnet, dass mindestens zwei in axialer Richtung der Empfangsspulenachse voneinander beabstandete, ausschließlich in radialer Richtung auf das Probenröhrchen (8) wirkende Zentrierungseinrichtungen vorgesehen sind, von denen eine im oberen Bereich (9a) und die andere im unteren Bereich (9b, 9b') des NMR-Empfangspulensystems (9a-k) angeordnet ist, sowie mindestens eine ausschließlich in axialer Richtung auf das Probenröhrchen (8) wirkende Positionierungseinrichtung, die sich entweder unterhalb (20a) oder oberhalb (17) des NMR-Empfangsspulensystems befinden kann, wobei die ausschließlich radial wirkenden Zentrierungseinrichtungen (9a, 9b, 9b') selber Bestandteile des NMR-Empfangspulensystems (9a-k) sind. Damit lässt sich die Zentrierungsgenauigkeit gegenüber bekannten Vorrichtungen steigern, um dadurch auch für Probengläschen in Form von Messkapillaren, bei denen die Anforderung an die Güte der Zentrierung am größten ist, optimale Resultate zu erreichen.

## Beschreibung

Die Erfindung betrifft eine Vorrichtung zur Zentrierung eines mit einer Messsubstanz gefüllten länglichen Probenröhrchens relativ zur Vertikalachse eines Kernspinresonanz (=NMR)-Empfangspulensystems, das in einer Trägervorrichtung starr befestigt ist.

Eine solche Vorrichtung ist bekannt aus der Firmenbroschüre "High Resolution NMR, Probeheads" der Bruker-Gruppe aus dem Jahr 1995.

In der NMR-Spektroskopie ist die exakte Zentrierung eines Probenröhrchens in Bezug auf die Sende- und Empfangsspule eine wichtige Voraussetzung, um eine möglichst hohe Empfindlichkeit des Spektrometers zu erreichen. Insbesondere muss die radiale Zentrierung besonders exakt erfolgen, da zur Erreichung eines möglichst hohen Füllfaktors, der Abstand zwischen dem Empfangsspulensystem und dem Probenröhrchen so klein wie möglich sein sollte. Bei immer kleiner werdenden Probenröhrchen muss der Abstand zwischen Empfangsspulensystem und Probenröhrchen linear kleiner werden, um denselben Füllfaktor beizubehalten, und die Anforderungen an die radiale Positionierungsgenauigkeit steigen deshalb ebenfalls linear an. Im Grenzfall, wenn das Probenröhrchen aus einer sogenannten Messkapillare besteht, sind deshalb die Anforderungen an die Genauigkeit der radialen Zentrierung ganz besonders hoch. Solche Messkapillaren werden vorwiegend dann verwendet, wenn die zur Verfügung stehende Menge an Messsubstanz sehr gering ist.

Bekannt sind Zentriervorrichtungen, die je nach Auslegung in verschiedene Genauigkeitsstufen eingeteilt werden können:

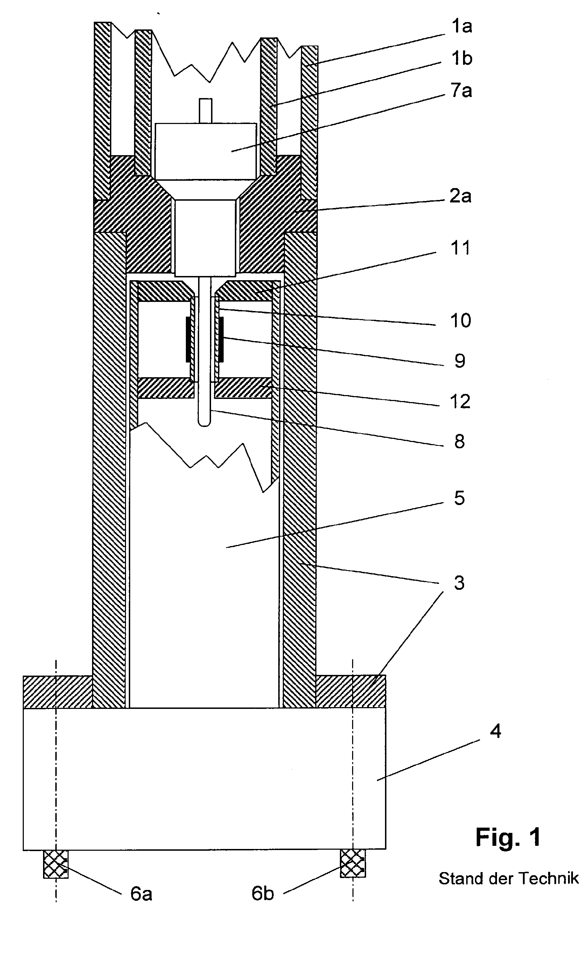

Die Genauigkeitsstufe 1 stellt die niedrigste Stufe bezüglich Genauigkeit der Zentrierung dar. Bekannt beispielsweise durch die eingangs zitierte Firmenbroschüre der Bruker AG ist eine Anordnung, wie sie in Fig. 1 dargestellt ist, wo das Probenröhrchen 8 in den Rotor 7a einer Luftturbine (= Spinner) gesteckt wird, und dieser Spinner auf der konischen Führungsfläche des Stators 2a der Luftturbine, die sich oberhalb des Empfangsspulensystems 9 befindet, axial und radial zentriert wird. Der Stator mit seiner konischen Führungsfläche steht nicht in direkter mechanischer Verbindung mit dem Empfangsspulensystem, sondern ist über den unteren Trägerteil 3, anschließend über den unteren Teil des Probenkopfes 4 und schließlich über den oberen Teil 5 des Probenkopfes mit der oberen und unteren Befestigung 11, 12 des Trägerröhrchens 10 des Empfangsspulensystems 9 verbunden. Die Position des Probenröhrchens in Bezug zum Empfangsspulensystem ist somit von sehr vielen Einzelteilen mit verschiedenen mechanischen Toleranzen abhängig, die sich im schlimmsten Fall addieren können und dadurch die Genauigkeit und Reproduzierbarkeit der Zentrierung verschlechtern.

Insbesondere muss erwähnt werden, dass die Distanz zwischen der konischen Führungsfläche und des Empfangsspulensystems relativ groß ist. Dies hat zur Folge, dass kleinste Winkelfehler in der Ausrichtung der Achse der konischen Führungsfläche einen großen Einfluss auf die Position des Probenröhrchens am Ort der Empfangspule haben. Dieser Einfluss ist umso größer, je größer die Distanz zwischen konischer Führungsfläche und Empfangsspulensystem ist.

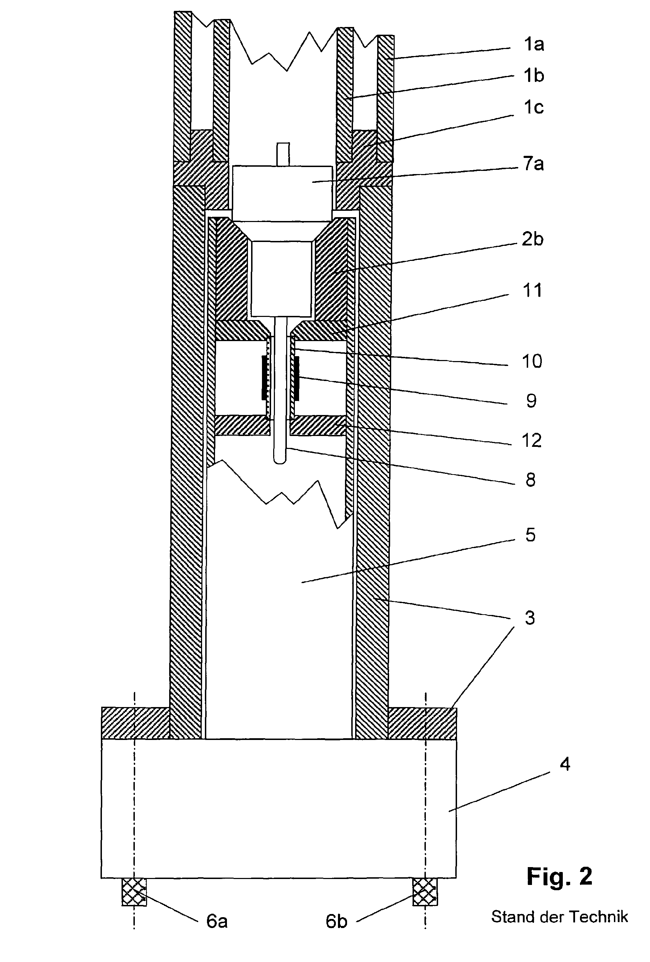

Eine Vorrichtung mit der nächsthöheren Genauigkeitsstufe 2 ist in Fig. 2 dargestellt. Sie erlaubt eine gegenüber der Vorrichtung nach Fig. 1 genauere Zentrierung des Probenröhrchens. Das Probenröhrchen steckt auch hier in einem Spinner 7a, der durch die konische Führungsfläche des Stators 2b einer Luftturbine, die sich oberhalb des Empfangsspulensystems 9 befindet, in axialer und radialer Richtung positioniert wird. Im Gegensatz zur Anordnung von Fig. 1 ist jedoch hier der Stator mit seiner konischen Führungsfläche direkt am oberen Teil 5 des Probenkopfes befestigt. Dadurch ist die konische Führungsfläche über weniger Zwischenteile mit dem Empfangsspulensystem verbunden, und damit sind weniger mechanische Toleranzen vorhanden, die sich addieren können.
Die Distanz zwischen der konischen Führungsfläche und des Empfangsspulensystems ist jedoch wie in Fig. 1 immer noch groß, so dass Winkelfehler in der Ausrichtung der konischen Führungsfläche auch in diesem Fall zu großen Positionierungsfehlern führen können.

Eine Vorrichtung mit der noch höheren Genauigkeitsstufe 3 ist in der DE 100 06 324 C1 beschrieben. Das Probenröhrchen steckt auch hier in einem Spinner, der durch die konische Führungsfläche des Stators einer Luftturbine, die sich oberhalb des Empfangsspulensystems befindet, in axialer und radialer Richtung positioniert wird. Die konische Führungsfläche ist ähnlich wie in Fig. 1 nicht direkt mit dem oberen Teil des Probenkopfes verbunden, sondern über diverse Trägerteile. Als wichtiges zusätzliches Merkmal besitzt die Vorrichtung jedoch eine zweite radiale Zentrierung, die unmittelbar unterhalb des Empfangsspulensystems angebracht ist. Dadurch lässt sich der Einfluss des Winkelfehlers der konischen Führungsfläche praktisch vollständig beheben, trotz der Tatsache, dass die Distanz zwischen konischer Führungsfläche und Empfangsspulensystem ähnlich groß ist wie in den Anordnungen von Fig.1 und Fig. 2.

Aufgabe der vorliegenden Erfindung ist es demgegenüber, mit möglichst einfachen technischen Mitteln die Zentrierungsgenauigkeit gegenüber den oben beschriebenen bekannten Vorrichtungen noch weiter zu steigern, um dadurch auch für Probengläschen in Form von Messkapillaren, bei denen die Anforderung an die Güte der Zentrierung am größten ist, optimale Resultate zu erreichen.

Erfindungsgemäß wird diese Aufgabe auf ebenso überraschend einfache wie wirkungsvolle Weise dadurch gelöst, dass mindestens zwei in axialer Richtung der Empfangsspulenachse voneinander beabstandete, ausschließlich in radialer Richtung auf das Probenröhrchen wirkende Zentrierungseinrichtungen vorgesehen sind, von denen eine am oberen Ende und die andere am unteren Ende des Empfangsspulensystems angeordnet ist, sowie mindestens eine ausschließlich in axialer Richtung auf das Probenröhrchen wirkende Positionierungseinrichtung, die sich entweder unterhalb oder oberhalb des NMR-Empfangsspulensystems befinden kann, wobei die ausschließlich radial wirkenden Zentrierungseinrichtungen selber Bestandteile des NMR-Empfangspulensystems sind.

Durch die beiden axial voneinander beabstandeten und ausschließlich radial wirkenden Zentrierungseinrichtungen kann eine optimale radiale Zentrierung des Probenröhrchens auch dann sichergestellt werden, wenn dieses einen sehr geringen Durchmesser aufweist, wie das bei üblichen Messkapillaren der Fall ist, die bei sehr geringen zu untersuchenden Substanzmengen eingesetzt werden. Die erfindungsgemäß vorgesehene starre mechanische Verbindung zwischen den beiden radial wirkenden Zentrierungseinrichtungen und dem NMR-Empfangsspulensystem stellt sicher, dass die radiale Zentrierung des Probenröhrchens zwangsläufig relativ zum NMR-Empfangsspulensystem erfolgt. Zusätzlich und unabhängig davon ist dann auch noch eine axiale Zentrierung vorgesehen. Damit kann insgesamt eine sehr hohe Genauigkeit der Zentrierung gewährleistet werden. Andererseits ist durch die Trennung der einzelnen Zentrierfunktionen ein besonders hoher Freiheitsgrad für die geometrische Ausgestaltung der gesamten Zentriervorrichtung vorhanden, so dass die Zentrierung geometrisch direkt am Empfangsspulensystem bewirkt werden kann.

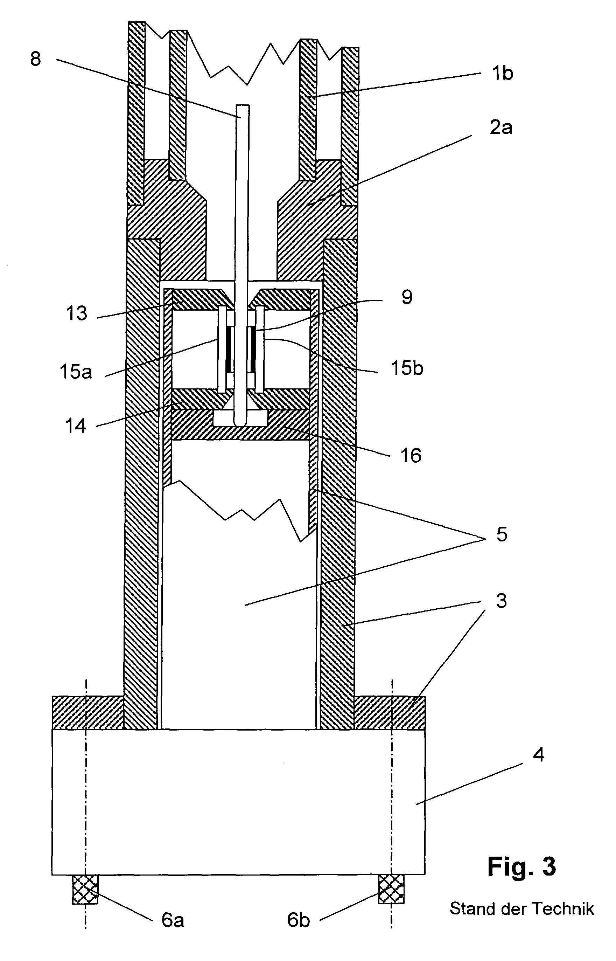

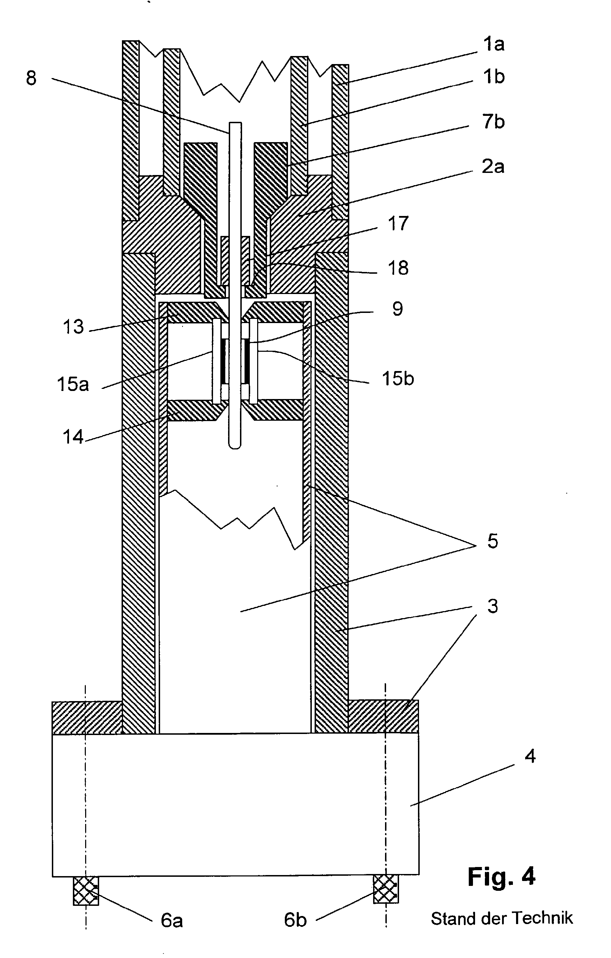

Eine ähnliche Vorrichtung, bei der jedoch die radialen Zentrierungseinrichtungen nicht Bestandteile des NMR-Empfangsspulensystems sind, sondern oberhalb und unterhalb desselben angeordnet sind, ist in der nachveröffentlichten DE 101 11 672 A1 beschrieben. Zwei Varianten dieser Vorrichtung nach dem genannten nachveröffentlichten Stand der Technik sind in den Figuren 3 und 4 dargestellt.

Da das NMR-Empfangsspulensystems 9 in den Figuren 3 und 4 im Extremfall einen Außendurchmesser von nur 1 bis 2 mm aufweisen kann, ist es sehr mühsam, dieses an der Innenseite der Trägerstangen 15a-c zu befestigen. Zudem besitzt das NMR-Empfangsspulensystem 9 eine geringe mechanische Eigenstabilität, da es aus einer dünnen, leitenden Metallfolie aufgebaut ist, welche die Form einer Sattelspule besitzt. Bereits schwache mechanische Störeinwirkungen oder Luftströmungen können dieses Empfangsspulensystem deshalb zum mechanischen Schwingen anregen und dadurch Störungen im NMR-Spektrum hervorrufen.

Für solche Extremfälle mit derart kleinen Dimensionen wird deshalb die erfindungsgemäße Vorrichtung vorgeschlagen, bei der das NMR-Empfangsspulensystem eine erhöhte Eigenstabilität besitzt und einfacher herzustellen und zu montieren ist. Erreicht wird dies dadurch, dass das NMR-Empfangsspulensystem nicht aus einer metallischen Folie, sondern aus einzelnen stabilen Einzelteilen zusammengesetzt ist, die relativ einfach miteinander verbunden werden können.

Eine besonders einfache Ausführungsform der erfindungsgemäßen Vorrichtung zeichnet sich dadurch aus, dass die ausschließlich in axialer Richtung auf Probenröhrchen wirkende Positionierungseinrichtung unterhalb des NMR-Empfangsspulensystems angeordnet ist und ein Anschlagteil umfasst, auf welchem das Probenröhrchen in Betriebsposition aufsitzt. Dadurch kann die axiale Zentrierung des Probenröhrchens technisch besonders unaufwändig, aber dennoch präzise gestaltet werden.

Alternativ dazu sieht eine weitere bevorzugte Ausführungsform der erfindungsgemäßen Vorrichtung vor, dass die ausschließlich in axialer Richtung auf das Probenröhrchen wirkende Positionierungseinrichtung oberhalb des NMR-Empfangsspulensystems angeordnet ist und eine manschettenartig und verrutschsicher radial um das Probenröhrchen herum angebrachte Befestigungshülse umfasst, die in Betriebsposition des Probenröhrchens mit einer horizontalen Abschlussfläche auf einer oberhalb des NMR-Empfangsspulensystems angeordneten horizontalen Anschlagfläche eben aufliegt. Diese Ausführungsform ist zwar technisch etwas aufwändiger als die zuvor beschriebene, dafür ermöglicht sie aber eine wesentlich einfachere Handhabung des Systems im Betrieb.

Bei einer besonders vorteilhaften Weiterbildung dieser Ausführungsform ist die Anschlagfläche für die Befestigungshülse im Bodenbereich auf der Innenseite eines Rotors vorgesehen, der Teil einer Luftturbine zur Positionierung und wahlweise zur Rotation des Probenröhrchens ist und eine zentrische axiale Innenbohrung mit einem größeren Durchmesser als dem Außendurchmesser der Befestigungshülse aufweist. Die Außenmaße der Luftturbine können ohne weiteres mit denen von konventionell nach dem Stand der Technik eingesetzten Spinnern übereinstimmen, so dass das System an bereits vorhandene Pneumatikeinrichtungen automatisch angepasst ist und keine Änderungen dieses Teils der Apparatur erforderlich werden.

Die Befestigungshülse bei diesen Ausführungsformen kann durch erhöhten Reibungskontakt verrutschsicher am Probenröhrchen angebracht sein. Es kann aber auch eine feste Verbindung mit dem Probenröhrchen, insbesondere eine Verklebung oder Verschweißung vorgesehen sein, so dass ein Verrutschen der Befestigungshülse beim Auftreffen in ihrer horizontalen Abschlussfläche auf die entsprechende Anschlagfläche absolut ausgeschlossen werden kann.

Eine bevorzugte Ausführungsform der Erfindung zeichnet sich dadurch aus, dass die beiden ausschließlich in radialer Richtung auf das Probenröhrchen wirkenden und zugleich zum NMR-Empfangsspulenssystem gehörenden Zentrierungseinrichtungen derart ausgeführt sind, dass die elektrisch leitende Scheibe der oberen Zentrierungseinrichtung mit dem oberen Teil der in axialer Richtung der Empfangsspulenachse orientierten Leiterteile des NMR-Empfangsspulensystems elektrisch verbunden ist, und dass die beiden elektrisch leitenden Halbscheiben der unteren Zentrierungseinrichtung mit dem unteren Teil der in axialer Richtung der Empfangsspulenachse orientierten Leiterteile des NMR-Empfangsspulensystems elektrisch verbunden sind und die beiden Anschlusselemente des NMR-Empfangsspulensystems bilden.

Vorzugsweise sind die Zentrierungseinrichtungen an elektrisch isolierenden Trägerstangen befestigt, die symmetrisch um das Probenröhrchen herum angeordnet sind.

Besonders bevorzugt sind genau vier Trägerstangen vorgesehen.

Die Trägerstangen sollten in jedem Falle aus einem elektrisch isolierenden Material gefertigt sein, das keinen Einfluss auf die NMR-Messungen ausübt. Vorteilhafterweise kann für die Trägerstangen Keramik-, Glas- oder Quarzmaterial verwendet werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:
- Fig. 1: einen schematischen Vertikalschnitt durch einen NMR-Probenkopf nach dem Stand der Technik mit Genauigkeitsstufe 1 der Zentrierung des Probenröhrchens;
- Fig. 2: einen schematischen Vertikalschnitt durch einen NMR-Probenkopf nach dem Stand der Technik mit Genauigkeitsstufe 2 der Zentrierung des Probenröhrchens;
- Fig. 3: einen schematischen Vertikalschnitt durch einen NMR-Probenkopf nach dem Stand der Technik gemäß der nachveröffentlichten DE 101 11 672 A1, ohne Spinner und mit unterem axialen Anschlag des Probenröhrchens;
- Fig. 4: einen schematischen Vertikalschnitt durch einen NMR-Probenkopf nach dem Stand der Technik gemäß der nachveröffentlichten DE 101 11 672 A1 mit modifiziertem Spinner und mit Befestigungshülse zur axialen Positionierung des Probenröhrchens;
- Fig. 5: einen schematischen Vertikalschnitt durch eine Ausführungsform des erfindungsgemäßen NMR-Probenkopfes ohne Spinner und mit unterem axialen Anschlag des Probenröhrchens;
- Fig. 6: einen schematischen Vertikalschnitt durch eine weitere Ausführungsform des erfindungsgemäßen NMR-Probenkopfes mit modifiziertem Spinner, und mit Befestigungshülse zur axialen Positionierung des Probenröhrchens;
- Fig. 7a: den Bereich um das NMR-Empfangsspulensystem einer Vorrichtung nach Fig. 6 in größerem Detail;
- Fig. 7b: einen Horizontalschnitt längs der Linie A - A' in Fig. 7a.
- Fig. 8a: eine 3D-Darstellung der ersten oben genannten erfindungsgemäßen Ausführungsform, bei der die Konstruktionsteile 9a, 9b und 9b' Bestandteile des Empfangsspulensystems sind und zugleich der radialen Zentrierung des Probenröhrchens dienen;
- Fig. 8b: eine vereinfachte 3D-Darstellung der Wirkungsweise des NMR-Empfangsspulensystems von Fig. 8a. bei der H1 das Hochfrequenzfeld ist, das vom Hochfrequenzstrom im Empfangsspulensystem erzeugt wird, und das zur Anregung der Spins im Probenröhrchen dient, wobei die dünnen Pfeile die Richtung des Hochfrequenzstromes angeben; und
- Fig. 9: einen Horizontalschnitt analog zu Fig. 7b der zweiten erfindungsgemäßen Ausführungsform, bei der das NMR-Empfangsspulensystem an Stelle der beiden einzelnen Längsleiter 9c und 9d jeweils drei einzelne Längsleiter 9e,f,g und 9h,i,k enthält.

Gemäß dem Stand der Technik, der in der nachveröffentlichten deutschen Offenlegungsschrift DE 101 11 672 A1 beschrieben ist, wird das Probenröhrchen unmittelbar oberhalb und unterhalb des Empfangsspulensystems mit Hilfe der beiden Zentriervorrichtungen 13 und 14 rein radial zentriert (Fig. 3). Da diese Zentrierung so nahe wie möglich beim NMR- Empfangsspulensystem 9 und mit möglichst wenig Zwischenteilen erfolgt, ist eine hohe Genauigkeit der Zentrierung gewährleistet. Wie nahe diese Zentrierung beim Empfangsspulensystem angebracht werden kann, hängt vom Einfluss der Suszeptibilität der verwendeten Materialien auf die NMR-Auflösung ab, was experimentell bestimmt werden kann.

Da bei der Vorrichtung gemäß der nachveröffentlichten
DE 101 11 672 A1 eine hohe radiale Zentriergenauigkeit erreicht wird, kann zudem das Empfangsspulensystem 9 im Innern ihrer Trägervorrichtung befestigt werden, d.h. unmittelbar um das Probenröhrchen 8 herum mit einem sehr geringen Abstand zueinander, wodurch der erreichbare Füllfaktor sehr hoch wird. Voraussetzung für eine solche Anordnung ist jedoch die hohe radiale Zentriergenauigkeit, die eine Beschädigung des Empfangsspulensystems 9 beim Einführen des Probenröhrchens 8 verhindert.

In der erfindungsgemäßen Vorrichtung ist keine separate radiale Zentriervorrichtung notwendig, da diese (9a, 9b, 9b') als Teil des NMR-Empfangsspulensystems realisiert ist. Das Probenröhrchen wird durch den oberen (9a) und unteren (9b, 9b') Teil des Empfangsspulensystems in radialer Richtung zentriert. Dadurch werden die beiden empfindlichsten Bestandteile der erfindungsgemäßen Vorrichtung, nämlich das Empfangsspulensystem und das Probenröhrchen, direkt aufeinander zentriert, und das ist mit dem höchstmöglichen Maß an Genauigkeit durchführbar.

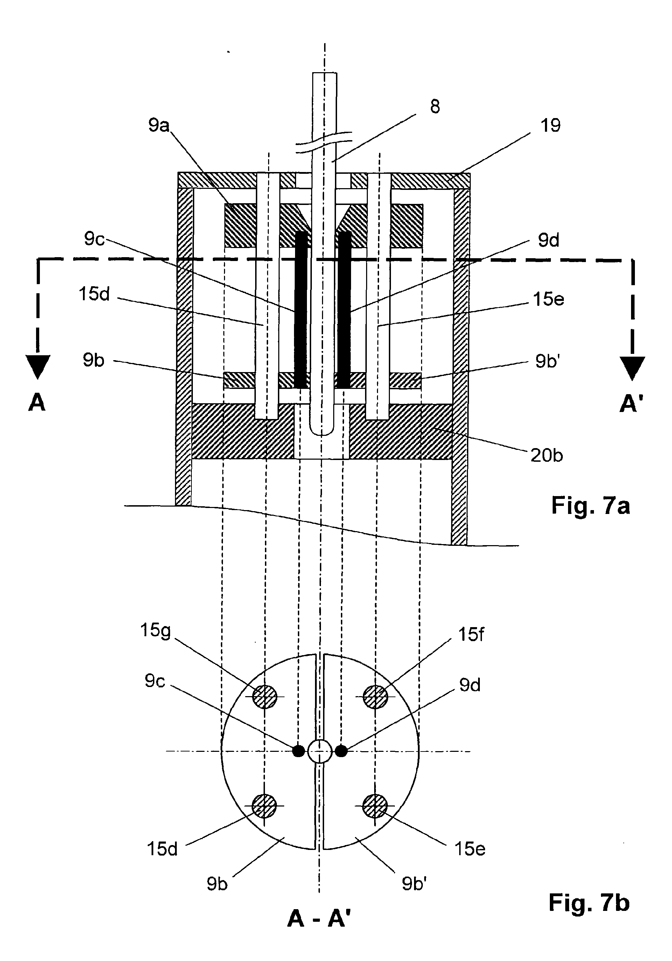

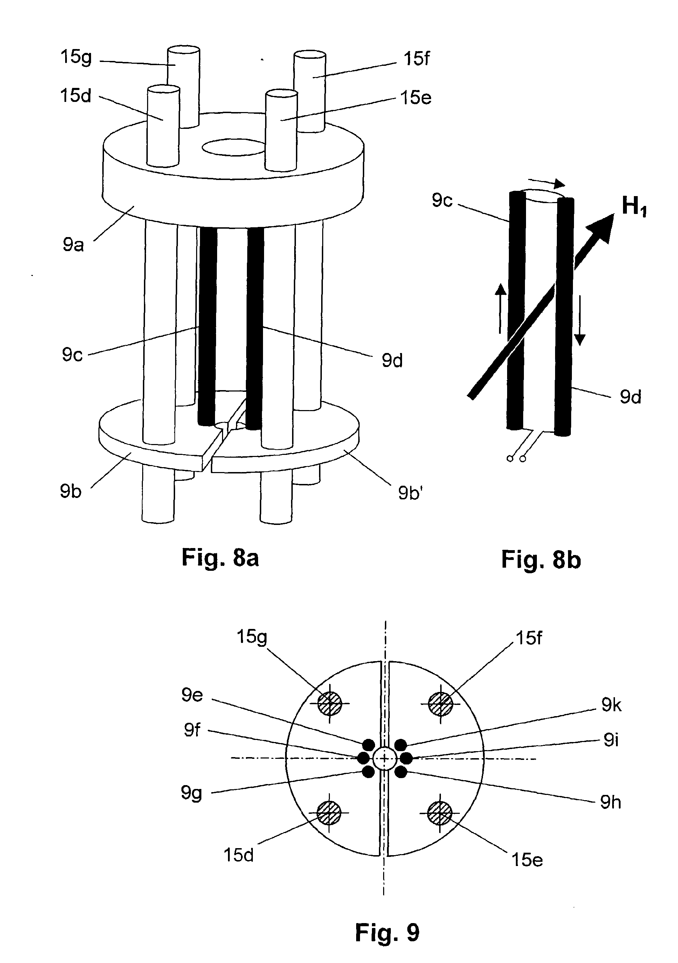

Um in der erfindungsgemäßen Vorrichtung einen möglichst hohen Füllfaktor des NMR-Empfangsspulensystems zu erreichen, werden die Hauptleiter des Empfangsspulensystems 9c,d oder 9e,f,g,h,i,k, die mit der radialen Zentriervorrichtung mechanisch und elektrisch verbunden sind, so nahe wie möglich um das Probenröhrchen herum angeordnet. Da die Genauigkeit der radialen Zentrierung besonders hoch ist, und da zudem die Hauptleiter mechanisch sehr stabil und deshalb nicht leicht zu beschädigen sind, lassen sich letztere besonders nahe am Probenröhrchen anordnen (Fig.7b, Fig.9), und das führt zwangsläufig zu einem besonders hohen Füllfaktor.

In einer ersten Variante (Fig.7a,b; Fig.8a, 8b) der erfindungsgemäßen Vorrichtung besitzt das NMR-Empfangsspulensystem nur zwei Hauptleiter 9c,d. Diese Variante zeichnet sich durch seine Einfachheit in der Herstellung und Montage aus. Das NMR-Empfangsspulensystem besteht hier aus fünf Einzelteilen, nämlich zwei Hauptleiter 9c,d, die parallel zur Achse des Empfangsspulensystems orientiert sind, eine elektrisch leitende Scheibe 9a, in welche die oberen Teile der zwei Hauptleiter hineingesteckt und dadurch miteinander elektrisch verbunden sind, sowie zwei elektrisch leitende Halbscheiben 9b, 9b', in welche der untere Teil je eines der beiden Hauptleiter hineingesteckt und dadurch mit der zugehörigen Halbscheibe elektrisch verbunden ist. Die einzelne Scheibe sowie die beiden Halbscheiben sind relativ groß und stabil aufgebaut und werden mit Hilfe von vorzugsweise vier elektrisch isolierenden Trägerstangen 15d-g mechanisch gegeneinander sowie in Bezug zum Probenkopf 19, 20a, 20b starr fixiert. Die Trägerstangen 15d-g sind vorzugsweise aus Keramik-, Glas- oder Quarzmaterial hergestellt. Zudem ist die Scheibe 9a sowie die beiden Halbscheiben 9b, 9b' derart ausgebildet, dass sie auch noch als radial wirkende Zentrierungseinrichtungen wirken und auf diese Weise die geforderte starre Verbindung zwischen Zentrierungseinrichtung und NMR-Empfangsspulensystem auf ideale Weise erfüllen.

In einer zweiten Variante (Fig. 9) der erfindungsgemäßen Vorrichtung werden die beiden Hauptleiter 9c, 9d jeweils durch drei Hauptleiter 9e,f,g und 9h,i,k ersetzt, die ebenfalls parallel zur Achse des NMR-Empfangsspulensystems orientiert sind. Das ganze NMR-Empfangsspulensystem besteht somit aus neun Einzelteilen 9a,b,b',e,f,g,h,i,k und besitzt gegenüber der ersten Variante den Vorteil eines größeren Q-Wertes, eines größeren Füllfaktors und eines homogeneren H₁-Feldes.

Dadurch werden die Hochfrequenz-Eigenschaften des NMR-Empfangsspulensystems signifikant verbessert. Erstens wird die Gesamtoberfläche pro Längeneinheit der Hauptleiter vergrößert, wodurch sein Hochfrequenz-Widerstand kleiner und sein Q-Wert erhöht wird. Zweitens erzeugt die Verteilung der Hauptleiter über einen größeren Bereich des Umfanges des Probenröhrchens eine verbesserte Homogenität des H1-Feldes in radialer Richtung und außerdem einen höheren Füllfaktor, da die Hauptleiter das Probenröhrchen über einen größeren Winkelbereich umschließen.

Man beachte, dass die beiden oben beschriebenen Ausführungsformen der erfindungsgemäßen Vorrichtung die Eigenschaft besitzen, dass das jeweils zugehörige NMR-Empfangsspulensystem nicht nur als Hochfrequenzresonator, sondern zudem und zugleich als radiale Zentrierungseinrichtung wirkt.

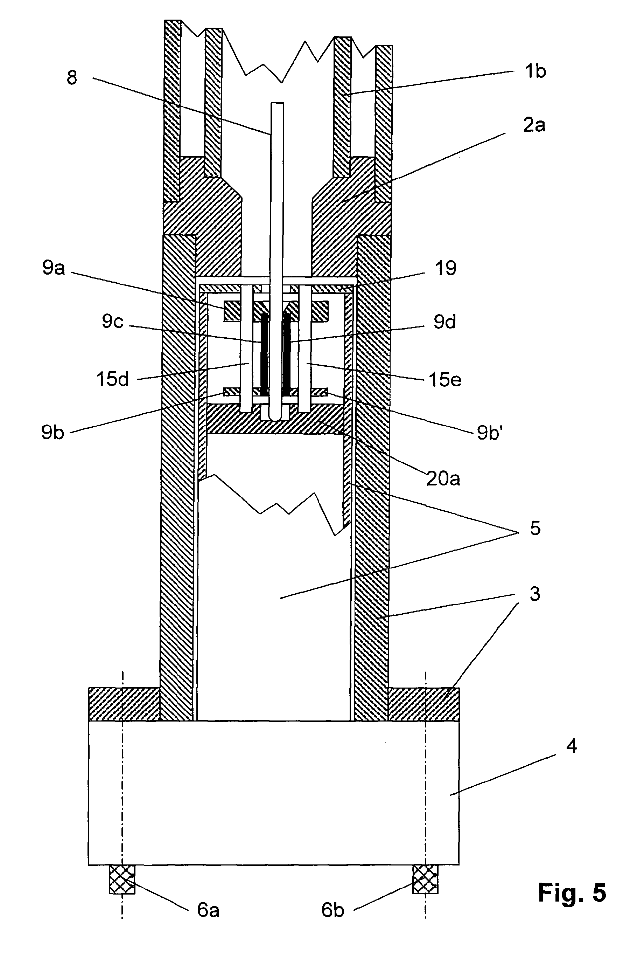

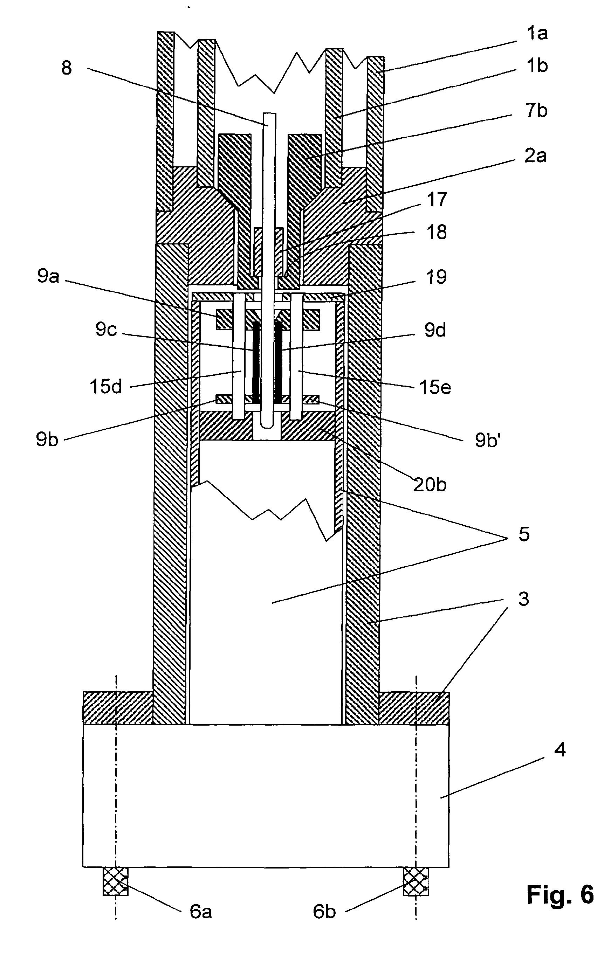

Die axiale Positionierung erfolgt getrennt, entweder unterhalb des NMR-Empfangsspulensystems 9a,b,b',c,d resp. 9a,b,b',e-k mit Hilfe eines Anschlagteils 20a wie in Fig. 5 dargestellt, oder oberhalb des NMR-Empfangsspulensystems, vorzugsweise innerhalb eines modifizierten Spinners 7b, mit Hilfe einer Befestigungshülse 17, wie in Fig. 6 dargestellt.

Fig. 5 zeigt eine Variante der erfindungsgemäßen Vorrichtung, bei der die axiale Positionierung des Probenröhrchens unterhalb des Empfangsspulensystems erfolgt, und zwar mit Hilfe des Anschlagteils 20a. Diese Variante besitzt den Vorteil, sehr einfach zu sein, hat jedoch den Nachteil, dass die Einführung des Probenröhrchens 8 nicht einfach ist. Von oben ist die Einführung nur mit einer Hilfsvorrichtung möglich, da das Führungsrohr 1b des Spinners relativ lang ist. Es besteht aber auch die Möglichkeit, dass der Probenkopf 4, 5 zuerst durch lösen der Schrauben 6a, 6b entfernt, das Probenröhrchen 8 anschließend in den Probenkopf gesteckt, und zum Schluss der Probenkopf wieder mit den Schrauben 6a, 6b montiert wird.

Fig. 6 zeigt eine axiale Positionierung des Probenröhrchens 8 mit Hilfe eines leicht modifizierten Spinners, der sich oberhalb des Empfangsspulensystems befindet. Es ist eine etwas aufwändigere Lösung, die aber sehr wichtige Vorteile besitzt, wie unten näher erläutert wird. Das Probenröhrchen 8 wird zuerst straff in eine Befestigungshülse 17 gesteckt, die sogar permanent mit dem Probenröhrchen 8 verklebt oder verschweißt sein darf.

Der Spinner 7b enthält im oberen Bereich eine vergrößerte Bohrung, in der die Befestigungshülse 17 lose, d.h. mit genügend Spielraum in radialer Richtung, Platz hat. Die Verengung im unteren Bereich des Spinners, auf deren Anschlagfläche 18 die Befestigungshülse 17 zum Aufliegen kommt, erzeugt die axiale Zentrierung.

Der Spinner 7b, dessen Außenmaße mit denen der konventionellen Spinner übereinstimmen, ist an eine bestehende Pneumatik angepasst, mit der er, auf einem Luftpolster liegend, von oben durch das Führungsrohr 1b nach unten, und umgekehrt von unten wieder nach oben befördert werden kann. Da sich die Befestigungshülse 17 innerhalb des Spinners 7b frei nach oben und in einem beschränkteren Maß auch seitlich bewegen kann, besteht keine Gefahr mehr, dass beim Hinunterfahren des Spinners die leicht zerbrechliche Messkapillare auf den konischen Teil der oberen Zentriervorrichtung 9a aufprallt und dort, durch das relativ große Gewicht des Spinners, zusätzliche Kräfte erfährt, die zu ihrem Bruch führen können. Dadurch, dass keine feste Verbindung zwischen der Befestigungshülse 17 und dem Spinner 7b besteht, kann die Messkapillare auf den konischen Teil der Zentriervorrichtung 9a aufprallen und sich dort problemlos zentrieren, während sich der Spinner 7b an ihr vorbei weiter nach unten bewegt, ohne jedoch die Befestigungshülse 17 samt Messkapillare mitzureißen und dadurch zusätzliche Kräfte auf die Messkapillare auszuüben.

Es muss an dieser Stelle betont werden, dass früher sehr häufig Glasbrüche entstanden, wenn die pneumatische Einrichtung benutzt wurde, um den Spinner samt Messkapillare hinunterzufahren. Mit der erfindungsgemäßen Ausgestaltung des Spinners 7b ist dieses Problem schlagartig verschwunden.

### Bezugszeichenliste

- 1a: Oberer Trägerteil (Außenmantel)
- 1 b: Oberer Trägerteil (Führungsrohr für den Spinner)
- 1 c: Oberer Trägerteil (unterer Abschlussflansch)
- 2a: Stator der Luftturbine von Fig. 1, Fig. 3 und Fig. 4
- 2b: Stator der Luftturbine von Fig. 2
- 3: Unterer Trägerteil
- 4: Unterer Teil des Probenkopfes
- 5: Oberer Teil des Probenkopfes
- 6a, b: Befestigungsschrauben. Diese sind von Hand abschraubbar, damit der Probenkopf leicht entfernt werden kann.
- 7a: Rotor (= Spinner) der Luftturbine von Fig. 1 und Fig. 2
- 7b: Rotor (= Spinner) der Luftturbine von Fig. 4. Diese erlaubt zugleich eine reine axiale Positionierung des Probenröhrchens 8
- 8: Probenröhrchen, das die zu messende Substanz enthält.
- 9: Empfangsspulensystem, das zum Stand der Technik gehört. Sie besteht aus einer dünnen, leitenden Folie und ist vorzugsweise sattelförmig gestaltet.
- 9a: Obere radial wirkende Zentrierungsvorrichtung, die zur ersten Variante der erfindungsgemäßen Ausführungsform gehört, und die elektrisch leitend und zugleich Teil des Empfangsspulensystems ist. Sie übernimmt die Funktion der oberen elektrischen Querverbindung des Empfangsspulensystems.
- 9b,b': Untere radialwirkende Zentrierungsvorrichtung, die zur ersten Variante der erfindungsgemäßen Ausführungsform gehört, und die elektrisch leitend und zugleich Teil des Empfangsspulensystems ist. Sie ist zweiteilig konstruiert und liefert die Anschlusspunkte des Empfangsspulensystems.
- 9c,d: Die beiden Hauptleiter des NMR-Empfangsspulensystems, das zur ersten Variante der erfindungsgemäßen Ausführungsform gehört. Beide Hauptleiter sind parallel zur Empfangsspulenachse orientiert und erzeugen im Wesentlichen das Hochfrequenzfeld H₁.
- 9e-g: Die erste Gruppe von drei Hauptleitern des NMR-Empfangsspulensystems, das zur zweiten Variante der erfindungsgemäßen Ausführungsform gehört. Die drei Leiter ersetzen den Einzelleiter 9c der ersten Variante.
- 9h-k: Die zweite Gruppe von drei Hauptleitern des NMR-Empfangsspulensystems, das zur zweiten Variante der erfindungsgemäßen Ausführungsform gehört. Die drei Leiter ersetzen den Einzelleiter 9d der ersten Variante.
- 10: Trägerröhrchen zur Befestigung des Empfangsspulensystems gemäß dem Stand der Technik.
- 11: Oberer Befestigungsteil des Trägerröhrchens 10 gemäß dem Stand der Technik.
- 12: Unterer Befestigungsteil des Trägerröhrchens 10 gemäß dem Stand der Technik.
- 13: Obere radialwirkende Zentrierungsvorrichtung gemäß der nachveröffentlichten DE 101 11 672 A1. Diese dient zugleich als obere Befestigung der drei Trägerstangen 15a, 15b und 15c des Empfangsspulensystems 9.
- 14: Untere radialwirkende Zentrierungsvorrichtung gemäß der nachveröffentlichten DE 101 11 672 A1. Diese dient zugleich als untere Befestigung der drei Trägerstangen 15a, 15b und 15c des Empfangsspulensystems 9.
- 15a-c: Drei elektrisch isolierende Trägerstangen gemäß der nachveröffentlichten DE 101 11 672 A1. Sie dienen der Befestigung des Empfangsspulensystems 9.
- 15d-g: Vier elektrisch isolierende Trägerstangen, die zu den erfindungsgemäßen Ausführungsformen gehören. Sie dienen der Befestigung der ersten (9a,b,b',c,d) oder zweiten (9a,b,b',e,f,g,h,i,k) Variante des NMR-Empfangsspulensystems.
- 16: Anschlagteil zur axialen Positionierung des Probenröhrchens
- 17: Befestigungshülse des Probenröhrchens. Sie erlaubt eine axiale Positionierung des Probenröhrchens im Spinner.
- 18: Anschlagfläche für die Befestigungshülse 17. Die Anschlagfläche dient der axialen Positionierung des Probenröhrchens
- 19: Oberer Befestigungsteil des NMR-Empfangsspulensystems, das zu den erfindungsgemäßen Ausführungsformen gehört.
- 20a: Unterer Befestigungsteil des NMR-Empfangsspulensystems, das zu den erfindungsgemäßen Ausführungsformen gehört. Dieser Befestigungsteil besitzt zusätzlich noch eine Anschlagfläche, auf der das Probenröhrchen axial positioniert wird.
- 20b: Unterer Befestigungsteil des NMR-Empfangsspulensystems, das zu den erfindungsgemäßen Ausführungsformen gehört. Dieser Befestigungsteil enthält ein Durchgangsloch an Stelle der axialen Positionierungsvorrichtung.

## Patentansprüche

1. Vorrichtung zur Positionierung eines mit einer Messsubstanz gefüllten länglichen Probenröhrchens (8) relativ zu einem Kernspinresonanz (=NMR)-Empfangspulensystem (9), das in einer Trägervorrichtung (10, 11, 12) starr befestigt ist,
**dadurch gekennzeichnet,**
**dass** mindestens zwei in axialer Richtung der Empfangsspulenachse voneinander beabstandete, ausschließlich in radialer Richtung auf das Probenröhrchen (8) wirkende Zentrierungseinrichtungen (9a, 9b, 9b') vorgesehen sind, von denen eine im oberen Bereich (9a) und die andere im unteren Bereich (9b, 9b') des NMR-Empfangspulensystems (9a-k) angeordnet ist, sowie mindestens eine ausschließlich in axialer Richtung auf das Probenröhrchen (8) wirkende Positionierungseinrichtung (17; 20a), die sich entweder unterhalb (20a) oder oberhalb (17) des NMR-Empfangsspulensystems (9a-k) befinden kann, wobei die ausschließlich radial wirkenden Zentrierungseinrichtungen (9a, 9b, 9b') selber Bestandteile des NMR-Empfangspulensystems (9a-k) sind.

2. Vorrichtung nach Anspruch 1, **dadurch gekennzeichnet, dass** die ausschließlich in axialer Richtung auf Probenröhrchen (8) wirkende Positionierungseinrichtung (20a) unterhalb des NMR-Empfangsspulensystems (9a-k) angeordnet ist und ein Anschlagteil (20a) umfasst, auf welchem das Probenröhrchen (8) in Betriebsposition aufsitzt.

3. Vorrichtung nach Anspruch 1, **dadurch gekennzeichnet, dass** die ausschließlich in axialer Richtung auf Probenröhrchen (8) wirkende Positionierungseinrichtung (17) oberhalb des NMR-Empfangsspulensystems (9a-k) angeordnet ist und eine manschettenartig und verrutschsicher radial um das Probenröhrchen (8) herum angebrachte Befestigungshülse (17) umfasst, die in Betriebsposition des Probenröhrchens (8) mit einer horizontalen Abschlussfläche auf einer oberhalb des NMR-Empfangsspulensystems (9a-k) angeordneten horizontalen Anschlagfläche (18) eben aufliegt.

4. Vorrichtung nach Anspruch 3, **dadurch gekennzeichnet, dass** die Anschlagfläche (18) für die Befestigungshülse (17) im Bodenbereich auf der Innenseite eines Rotors (7b) vorgesehen ist, der Teil einer Luftturbine zur Positionierung und wahlweise zur Rotation des Probenröhrchens (8) ist und eine zentrische axiale Innenbohrung mit einem größeren Durchmesser als dem Außendurchmesser der Befestigungshülse (17) aufweist.

5. Vorrichtung nach einem der Ansprüche 3 oder 4, **dadurch gekennzeichnet, dass** die Befestigungshülse (17) fest mit dem Probenröhrchen (8) verbunden, insbesondere verklebt oder verschweißt ist.

6. Vorrichtung nach einem der vorhergehenden Ansprüche, **dadurch gekennzeichnet, dass** die beiden ausschließlich in radialer Richtung auf das Probenröhrchen (8) wirkenden und zugleich zum NMR-Empfangsspulenssystem (9a-k) gehörenden Zentrierungseinrichtungen (9a, 9b, 9b') derart ausgeführt sind, dass die elektrisch leitende Scheibe (9a) der oberen Zentrierungseinrichtung (9a) mit dem oberen Teil der in axialer Richtung der Empfangsspulenachse orientierten Leiterteile (9c-d; 9e-k) des NMR-Empfangsspulensystems (9a-k) elektrisch verbunden ist, und dass die beiden elektrisch leitenden Halbscheiben (9b,9b') der unteren Zentrierungseinrichtung (9b, 9b') mit dem unteren Teil der in axialer Richtung der Empfangsspulenachse orientierten Leiterteile (9c-d; 9e-k) des NMR-Empfangsspulensystems (9a-k) elektrisch verbunden sind und die beiden Anschlusselemente des NMR-Empfangsspulensystems (9a-k) bilden.

7. Vorrichtung nach Anspruch 6, **dadurch gekennzeichnet, dass** die Zentrierungseinrichtungen (9a, 9b, 9b') an elektrisch isolierenden Trägerstangen (15d-g) befestigt sind, die symmetrisch um das Probenröhrchen (8) herum angeordnet sind.

8. Vorrichtung nach Anspruch 7, **dadurch gekennzeichnet, dass** vier Trägerstangen (15d-g) vorgesehen sind.

9. Vorrichtung nach einem der Ansprüche 7 oder 8, **dadurch gekennzeichnet, dass** die elektrisch isolierenden Trägerstangen (15a-g) aus Keramik-, Glas- oder Quarzmaterial aufgebaut sind.
